# EUROPEAN PATENT APPLICATION

(11) **EP 4 633 311 A2**
(43) Date of publication of application: **15.10.2025**
(21) Application number: 25164640.2
(22) Date of filing: 19.03.2025
(51) Int. Cl.: H05K 7/20

(54) **DUAL POSITION REFRIGERATION PIPING**

(30) Priority: 10.04.2024 US 202463632355 P
(71) Applicant: Vertiv Corporation, Westerville, OH 43082 (US)
(72) Inventor: ALVAREZ, Simon, Nuevo Leon (MX); HIJAR, ALEJANDRA SANCHEZ, Nuevo Leon (MX); ST. CLAIR, JEFF LEROY, White House, 37188 (US); INZUNZA, FRANCISCO, 66238 Nuevo Leon (MX)
(74) Representative: Bryn-Jacobsen, Caelia

(57) **Abstract**

An in-row cooling unit can include a cabinet, an evaporator within the cabinet and configured to transfer heat within the cabinet to a two-phase refrigerant within the evaporator, a compressor within the cabinet and fluidically coupled to the evaporator, a first coupler configured to selectively fluidically couple the evaporator to a condenser external to the cabinet, a second coupler configured to selectively fluidically couple the compressor to the condenser, a first through-pipe configured to selectively fluidically couple the first coupler to the condenser through a top of the cabinet or a bottom of the cabinet, and a second through-pipe configured to selectively fluidically couple the second coupler to the condenser through the top of the cabinet or the bottom of the cabinet.

## Description

### CROSS REFERENCE TO RELATED APPLICATIONS

This application claims the benefit of U.S. Provisional Patent Application No. 63/632,355 filed April 10, 2024.

### TECHNICAL FIELD

The present disclosure relates generally to data center cooling and more specifically relates to piping for in-row cooling units.

### BACKGROUND

When designing a data center, such as those with in-row cooling units, it is currently necessary to decide, early on, whether piping for those units will enter from the top or the bottom. As things change, as often happens, it can be difficult to convert an in-row cooling unit from top to bottom entry and vice versa. Such conversion often requires cutting existing piping, routing, and soldering new piping, and/or other tasks that can be difficult to perform on-site. Additionally, current in-row cooling units with top entry are often difficult to get through a normal-sized door.

### SUMMARY

The present disclosure provides new and useful devices, systems, and methods for piping of in-row cooling units. In at least one example, an in-row cooling unit according to the disclosure can include a cabinet, an evaporator within the cabinet and configured to transfer heat within the cabinet to a two-phase refrigerant within the evaporator, a compressor within the cabinet and fluidically coupled to the evaporator, a first coupler configured to selectively fluidically couple the evaporator to a condenser external to the cabinet, a second coupler configured to selectively fluidically couple the compressor to the condenser, internal piping rigidly mounted within the cabinet, a first through-pipe configured to selectively fluidically couple the first coupler to the condenser through a top of the cabinet and selectively fluidically couple the first coupler to the condenser through a bottom of the cabinet, a second through-pipe configured to selectively fluidically couple the second coupler to the condenser through the top of the cabinet and selectively fluidically couple the second coupler to the condenser through the bottom of the cabinet, or any combination thereof. In at least one example, the compressor can compress the two-phase refrigerant received from the evaporator. In at least one example, the internal piping can fluidically couple the evaporator, the compressor, and the couplers.

In at least one example, the first through-pipe can be removably coupled to the first coupler. In at least one example, the second through-pipe can be removably coupled to the second coupler.

In at least one example, the first coupler can selectively isolate the evaporator from the condenser. In at least one example, the first coupler can include a first valve to selectively fluidically couple the evaporator to the condenser and/or selectively isolate the evaporator from the condenser. In at least one example, the first coupler can include a liquid line service port.

In at least one example, the second coupler can selectively isolate the compressor from the condenser. In at least one example, the second coupler can include a second valve to selectively fluidically couple the compressor to the condenser and/or selectively isolate the compressor from the condenser. In at least one example, the second coupler can include a compressor discharge service port.

In at least one example, the internal piping can include an isolatable section between the first coupler and the evaporator. In at least one example, a refrigerant drier can be plumbed within the isolatable section. In at least one example, a third coupler can be plumbed between the evaporator and the drier. In at least one example, the third coupler can selectively fluidically couple the evaporator to the drier and/or selectively isolate the evaporator from the drier. In at least one example, the third coupler can include a third valve to selectively fluidically couple the evaporator to the drier and/or selectively isolate the evaporator from the drier. In at least one example, the couplers can cooperate to isolate a first portion of the refrigerant in the internal piping, a second portion of the refrigerant in the through-pipes, a third portion of the refrigerant in the isolatable section, or any combination thereof. In at least one example, the couplers can permit the drier to be replaced without evacuating the first portion of the refrigerant and/or without evacuating the second portion of the refrigerant.

In at least one example, a method of installing and/or maintaining an in-row cooling unit can include installing a cabinet of the cooling unit in a data center, loosening a first coupler within the cabinet fluidically coupled to internal piping rigidly mounted within the cabinet and an evaporator within the cabinet, moving a first through-pipe from a first bottom entry position to a first top entry position, tightening the first coupler, loosening a second coupler within the cabinet fluidically coupled to the internal piping rigidly mounted within the cabinet and a compressor within the cabinet, moving a second through-pipe from a second bottom entry position to a second top entry position, tightening the second coupler, coupling the through-pipes to a condenser external to the cabinet, or any combination thereof. In at least one example, tightening the first coupler can include fluidically coupling the first through-pipe to the evaporator in the first top entry position. In at least one example, tightening the second coupler can include fluidically coupling the second through-pipe to the compressor in the second top entry position.

In at least one example, loosening the first coupler can fluidically isolate the first through-pipe from the evaporator. In at least one example, moving the first through-pipe from the first bottom entry position to the first top entry position can include rotating the first through-pipe about the first coupler. In at least one example, tightening the first coupler can fluidically couple the first through-pipe to the evaporator through the internal piping.

In at least one example, loosening the second coupler can fluidically isolate the second through-pipe from the compressor. In at least one example, moving the second through-pipe from the second bottom entry position to the second top entry position can include rotating the second through-pipe about the second coupler. In at least one example, tightening the second coupler can fluidically couple the second through-pipe to the compressor through the internal piping.

In at least one example, a method of installing and/or maintaining an in-row cooling unit can include manipulating the first coupler, manipulating a third coupler plumbed between the first coupler and the evaporator, removing a first drier, installing a second drier between the first coupler and the third coupler, manipulating the first coupler and the third coupler again, or any combination thereof.

In at least one example, manipulating the first coupler can isolate the first drier from the evaporator and/or the condenser. In at least one example, manipulating the third coupler can isolate the first drier from the evaporator and/or the condenser. In at least one example, the first drier can be plumbed between the first coupler and the third coupler. In at least one example, manipulating the first coupler and the third coupler can fluidically couple the second drier with the evaporator and/or the condenser.

In at least one example, isolating the first drier from the evaporator and the condenser can include trapping a first portion of the refrigerant in the internal piping, the evaporator, and the compressor. In at least one example, isolating the first drier from the evaporator and the condenser can include trapping a second portion of the refrigerant in the through-pipes and the condenser. In at least one example, removing the first drier can include decoupling the first dryer from the first coupler and the third coupler without evacuating the first portion of the refrigerant and/or without evacuating the second portion of the refrigerant. In at least one example, the first drier can be swapped for the second drier without evacuating the first portion of the refrigerant and/or without evacuating the second portion of the refrigerant.

### BRIEF DESCRIPTION OF THE DRAWINGS

The disclosure will be readily understood by the following detailed description in conjunction with the accompanying drawings, wherein like reference numerals designate like elements:
FIG. 1 is a perspective view of an in-row cooling unit according to an exemplary example of the present disclosure, showing a top entry configuration;
FIG. 2 is a perspective view of the in-row cooling unit of FIG. 1, showing a bottom entry configuration;
FIG. 3 is a perspective view of an in-row cooling unit according to an exemplary example of the present disclosure, showing a bottom entry configuration;
FIG. 4 is a close-up perspective view of a portion of the in-row cooling unit of FIG. 3;
FIG. 5 is a perspective view of the in-row cooling unit of FIG. 3, showing a top entry configuration;
FIG. 6 is a close-up perspective view of a portion of an in-row cooling unit according to an exemplary example of the present disclosure;
FIG. 7 is a close-up perspective view of another portion of an in-row cooling unit according to an exemplary example of the present disclosure;
FIG. 8 is a simplified schematic of an in-row cooling unit according to exemplary examples of the present disclosure; and
FIG. 9 is a flowchart of a method according to an exemplary example of the present disclosure.

### DETAILED DESCRIPTION

The figures described above and the written description of specific structures and functions below are not presented to limit the scope of what Applicant have invented or the scope of the appended claims. Rather, the figures and written description are provided to teach any person skilled in the art to make and use the inventions for which patent protection is sought. Those skilled in the art will appreciate that not all features of a commercial example of the inventions are described or shown for the sake of clarity and understanding. Persons of skill in this art will also appreciate that the development of an actual commercial example incorporating aspects of the present inventions will require numerous implementation-specific decisions to achieve the developer's ultimate goal for the commercial example. Such implementation-specific decisions may include, and likely are not limited to, compliance with system-related, business-related, government-related and other constraints, which may vary by specific implementation, location and from time to time. While a developer's efforts might be complex and time-consuming in an absolute sense, such efforts would be, nevertheless, a routine undertaking for those of skill in this art having benefit of this disclosure. It must be understood that the inventions disclosed and taught herein are susceptible to numerous and various modifications and alternative forms.

The use of a singular term, such as, but not limited to, "a," is not intended as limiting of the number of items. Also, the use of relational terms, such as, but not limited to, "top," "bottom," "left," "right," "upper," "lower," "down," "up," "side," and the like are used in the written description for clarity in specific reference to the figures and are not intended to limit the scope of the inventions or the appended claims. The terms "including" and "such as" are illustrative and not limitative. The terms "couple," "coupled," "coupling," "coupler," and like terms are used broadly herein and can include any method or device for securing, binding, bonding, fastening, attaching, joining, inserting therein, forming thereon or therein, communicating, or otherwise associating, for example, mechanically, magnetically, electrically, chemically, operably, directly or indirectly with intermediate elements, one or more pieces of members together and can further include without limitation integrally forming one functional member with another in a unity fashion. The coupling can occur in any direction, including rotationally. Further, all parts and components of the disclosure that are capable of being physically embodied inherently include imaginary and real characteristics regardless of whether such characteristics are expressly described herein, including but not limited to characteristics such as axes, ends, inner and outer surfaces, interior spaces, tops, bottoms, sides, boundaries, dimensions (e.g., height, length, width, thickness), mass, weight, volume and density, among others.

Applicant has created new and useful devices, systems and methods for piping of in-row cooling units. In at least one example, an in-row cooling unit according to the disclosure can accommodate top and/or bottom entry of cooling fluids, and can simplify on-site installation and/or modification. For example, in at least one example, an in-row cooling unit according to the disclosure can include two or more couplers configured to selectively fluidically couple internal components to a condenser external to the cabinet and two or more through-pipes configured to selectively fluidically couple the couplers to the condenser through a top of the cabinet and selectively fluidically couple the couplers to the condenser through a bottom of the cabinet.

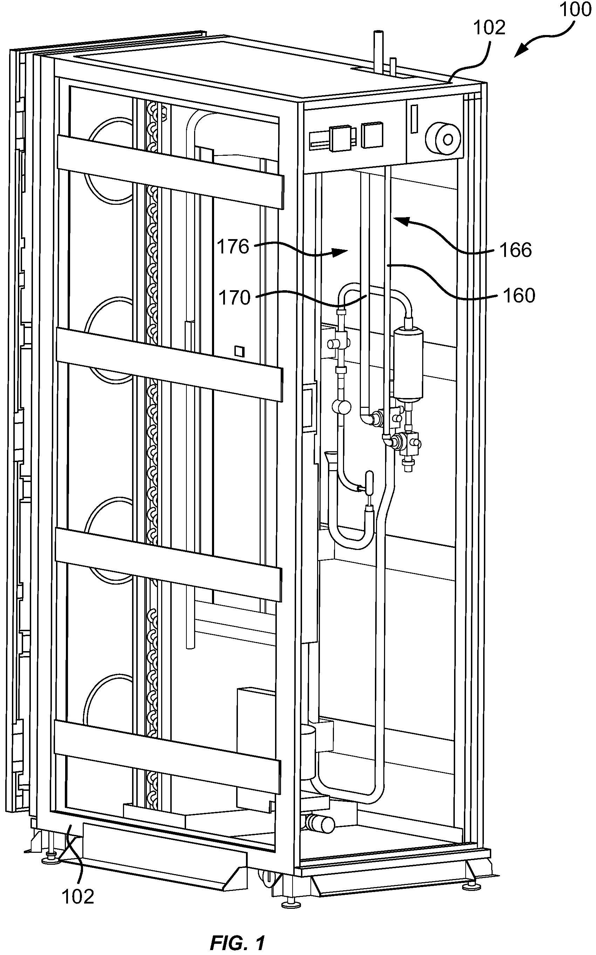

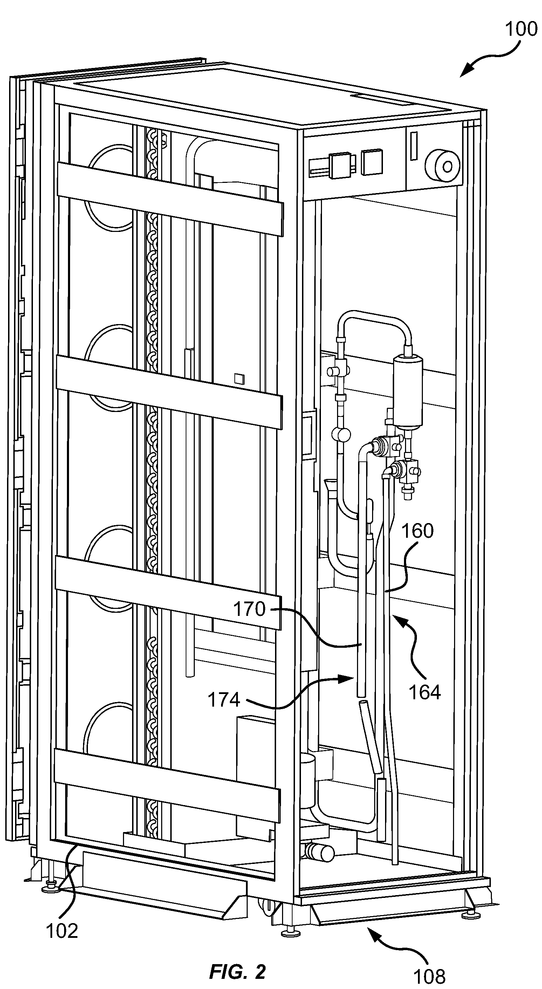

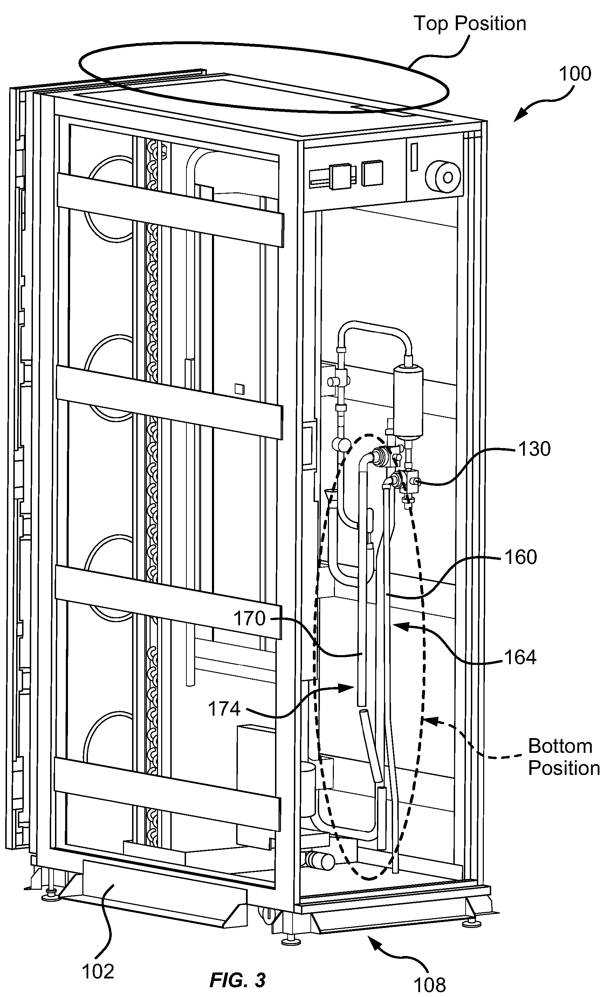

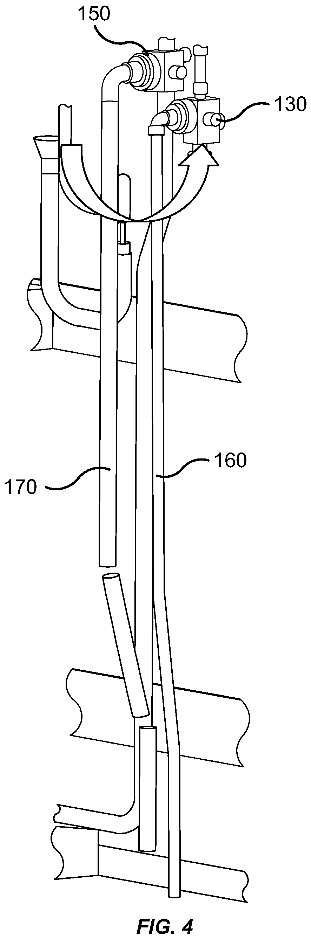

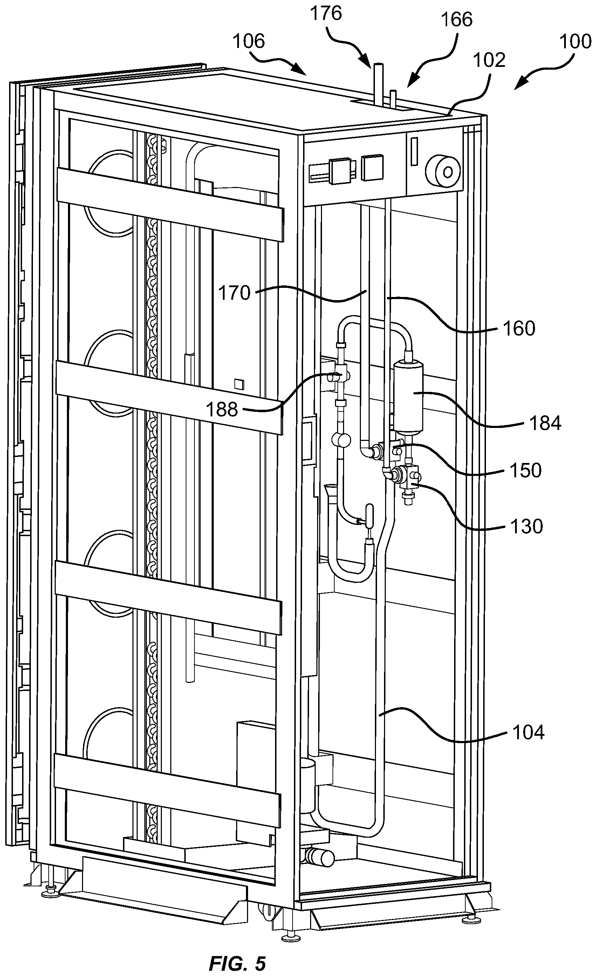

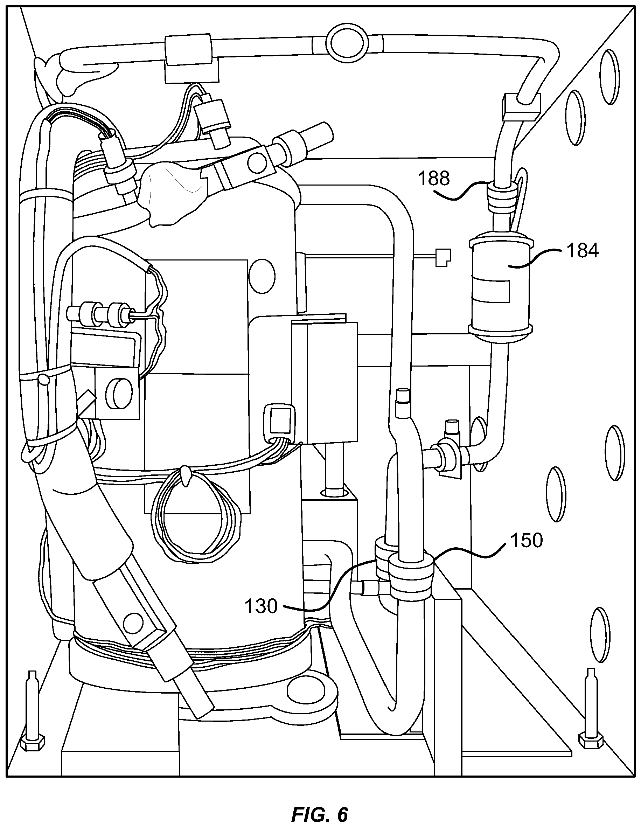

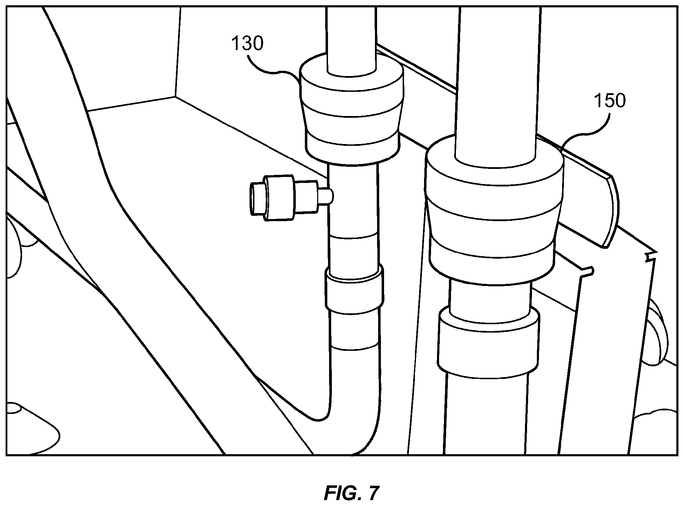

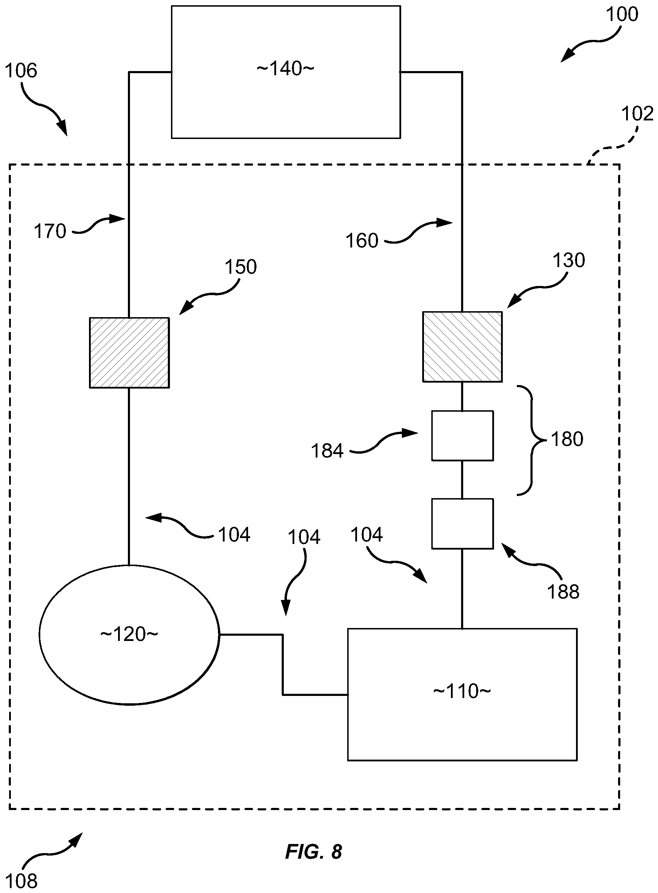

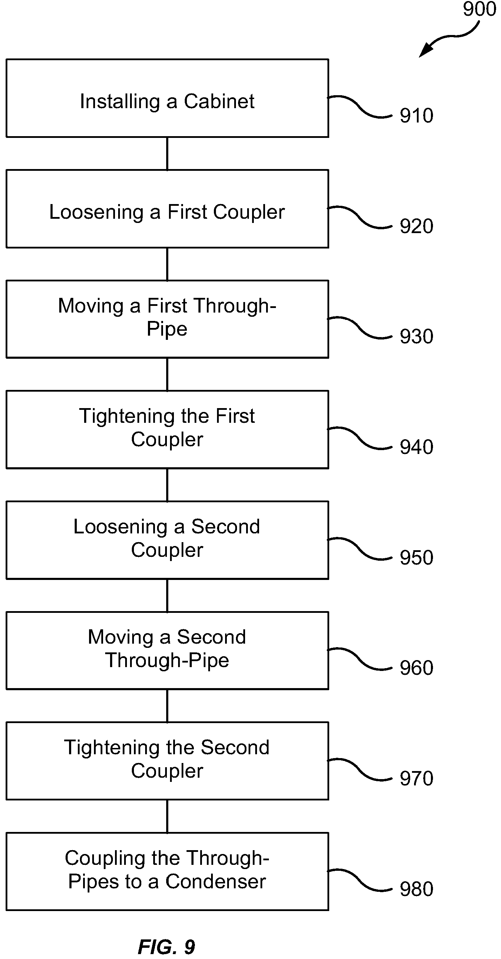

FIG. 1 is a perspective view of one of many examples of an in-row cooling unit according to the disclosure, showing a top entry configuration. FIG. 2 is a perspective view of the in-row cooling unit of FIG. 1, showing a bottom entry configuration. FIG. 3 is a perspective view of one of many examples of an in-row cooling unit according to the disclosure, showing a bottom entry configuration. FIG. 4 is a close-up perspective view of a portion of the in-row cooling unit of FIG. 3. FIG. 5 is a perspective view of the in-row cooling unit of FIG. 3, showing a top entry configuration. FIG. 6 is a close-up perspective view of a portion of one of many examples of an in-row cooling unit according to the disclosure. FIG. 7 is a close-up perspective view of another portion of one of many examples of an in-row cooling unit according to the disclosure. FIG. 8 is a simplified schematic of one of many examples of an in-row cooling unit according to the disclosure. FIG. 9 is a flowchart of a method according to an exemplary example of the present disclosure. FIGS. 1-9 are described in conjunction with one another.

In at least one example, an in-row cooling unit 100 according to the disclosure can include one or more cabinets 102, one or more evaporators 110 within the cabinet 102 and configured to transfer heat within the cabinet 102 to a two-phase refrigerant within the evaporator 110, and one or more compressors 120 within the cabinet 102 and fluidically coupled to the evaporator 110. The in-row cooling unit 100 can further include at least one first coupler 130 configured to selectively fluidically couple the evaporator 110 to one or more condensers 140 external to the cabinet 102, and at least one second coupler 150 configured to selectively fluidically couple the compressor 120 to the condenser 140. In addition, the in-row cooling unit 100 may include internal piping 104 rigidly mounted within the cabinet 102, and one or more first through-pipes 160 configured to selectively fluidically couple the first coupler 130 to the condenser 140 through a top 106 of the cabinet 102 and selectively fluidically couple the first coupler 130 to the condenser 140 through a bottom 108 of the cabinet 102. One or more second through-pipes 170 may be configured to selectively fluidically couple the second coupler 150 to the condenser 140 through the top 106 of the cabinet 102 and selectively fluidically couple the second coupler 150 to the condenser 140 through the bottom 108 of the cabinet 102, or any combination thereof.

In at least one example, the in-row cooling unit 100 can be similar to those currently available from Vertiv Group Corp., such as the Liebert^{®} CRV line of cooling units. In at least one example, the compressor 120 can compress the two-phase refrigerant received from the evaporator 110. In at least one example, the internal piping 104 can fluidically couple the evaporator 110, the compressor 120, and the couplers 130, 150.

In at least one example, the first through-pipe 160 can be removably and/or rotatably coupled to the first coupler 130. In at least one example, the second through-pipe 170 can be removably and/or rotatably coupled to the second coupler 150.

In at least one example, the first coupler 130 can selectively isolate the evaporator 110 from the condenser 140. In at least one example, the first coupler 130 can include a first valve to selectively fluidically couple the evaporator 110 to the condenser 140 and/or selectively isolate the evaporator 110 from the condenser 140. In at least one example, the first coupler 130 can include a liquid line service port.

In at least one example, the second coupler 150 can selectively isolate the compressor 120 from the condenser 140. In at least one example, the second coupler 150 can include a second valve to selectively fluidically couple the compressor 120 to the condenser 140 and/or selectively isolate the compressor 120 from the condenser 140. In at least one example, the second coupler 150 can include a compressor discharge service port.

In at least one example, the internal piping 104 can include an isolatable section 180 between the first coupler 130 and the evaporator 110. In at least one example, a refrigerant drier 184 can be plumbed within the isolatable section 180. In at least one example, a third coupler 188 can be plumbed between the evaporator 110 and the drier 184. In at least one example, the third coupler 188 can selectively fluidically couple the evaporator 110 to the drier 184 and/or selectively isolate the evaporator 110 from the drier 184. In at least one example, the third coupler 188 can include a third valve to selectively fluidically couple the evaporator 110 to the drier 184 and/or selectively isolate the evaporator 110 from the drier 184.

In at least one example, the couplers 130, 150, 188, or any of them, can permit the drier 184 to be replaced without evacuating the first portion of the refrigerant and/or without evacuating the second portion of the refrigerant. For example, the couplers 130, 150, 188, or any of them, can cooperate to isolate a first portion of the refrigerant in the internal piping 104, a second portion of the refrigerant in the through-pipes 160, 170, a third portion of the refrigerant in the isolatable section 180, or any combination thereof.

In at least one example, a method 900 according to the disclosure, such as a method of installing and/or maintaining an in-row cooling unit 100, can include step 910 of installing a cabinet 102 of the cooling unit 100 in a data center, step 920 of loosening a first coupler 130 within the cabinet 102 fluidically coupled to internal piping 104 mounted within the cabinet 102 and an evaporator 110 within the cabinet 102, step 930 of moving a first through-pipe 160 from a first bottom entry position 164 to a first top entry position 166, or any combination thereof. In at least one example, method 900 can include step 940 of tightening the first coupler 130, step 950 of loosening a second coupler 150 within the cabinet 102 fluidically coupled to the internal piping 104 mounted within the cabinet 102 and a compressor 120 within the cabinet 102, step 960 of moving a second through-pipe 170 from a second bottom entry position 174 to a second top entry position 176, or any combination thereof. In at least one example, method 900 can include step 970 of tightening the second coupler 150, step 980 of coupling the through-pipes 160, 170 to a condenser 140 external to the cabinet 102, or any combination thereof. In at least one example, tightening the first coupler 130 can include fluidically coupling the first through-pipe 160 to the evaporator 110 in the first top entry position 166. In at least one example, tightening the second coupler 150 can include fluidically coupling the second through-pipe 170 to the compressor 120 in the second top entry position 176.

In at least one example, loosening the first coupler 130 can fluidically isolate the first through-pipe 160 from the evaporator 110. In at least one example, moving the first through-pipe 160 from the first bottom entry position 164 to the first top entry position 166 can include rotating the first through-pipe 160 about the first coupler 130. In at least one example, tightening the first coupler 130 can fluidically couple the first through-pipe 160 to the evaporator 110 through the internal piping 104.

In at least one example, loosening the second coupler 150 can fluidically isolate the second through-pipe 170 from the compressor 120. In at least one example, moving the second through-pipe 170 from the second bottom entry position 174 to the second top entry position 176 can include rotating the second through-pipe 170 about the second coupler 150. In at least one example, tightening the second coupler 150 can fluidically couple the second through-pipe 170 to the compressor 120 through the internal piping 104.

In at least one example, a method of installing and/or maintaining an in-row cooling unit 100 can include manipulating the first coupler 130, manipulating a third coupler 188 plumbed between the first coupler 130 and the evaporator 110, removing a first drier 184, installing a second drier 184 between the first coupler 130 and the third coupler 188, manipulating the first coupler 130 and the third coupler 188 again, or any combination thereof.

In at least one example, manipulating the first coupler 130 can isolate the first drier 184 from the evaporator 110 and/or the condenser 140. In at least one example, manipulating the third coupler 188 can isolate the first drier 184 from the evaporator 110 and/or the condenser 140. In at least one example, the first drier 184 can be plumbed between the first coupler 130 and the third coupler 188. In at least one example, manipulating the first coupler 130 and the third coupler 188 can fluidically couple the second drier 184 with the evaporator 110 and/or the condenser 140.

In at least one example, isolating the drier 184 from the evaporator 110 and the condenser 140 can include trapping a first portion of the refrigerant in the internal piping 104, the evaporator 110, the compressor 120, or any combination thereof. In at least one example, isolating the drier 184 from the evaporator 110 and the condenser 140 can include trapping a second portion of the refrigerant in the through-pipes 160, 170, the condenser 140, or any combination thereof. In at least one example, the drier 184 can be swapped or replaced for another drier 184 without evacuating the first portion of the refrigerant and/or without evacuating the second portion of the refrigerant. In at least one example, removing the drier 184 can include decoupling the dryer 184 from the first coupler 130 and the third coupler 188 without evacuating the first portion of the refrigerant and/or without evacuating the second portion of the refrigerant.

In at least one example, an in-row cooling unit according to the disclosure can include a cabinet, an evaporator within the cabinet and configured to transfer heat within the cabinet to a two-phase refrigerant within the evaporator, a compressor within the cabinet and fluidically coupled to the evaporator, a first coupler configured to selectively fluidically couple the evaporator to a condenser external to the cabinet, a second coupler configured to selectively fluidically couple the compressor to the condenser, internal piping rigidly mounted within the cabinet, a first through-pipe configured to selectively fluidically couple the first coupler to the condenser through a top of the cabinet and selectively fluidically couple the first coupler to the condenser through a bottom of the cabinet, a second through-pipe configured to selectively fluidically couple the second coupler to the condenser through the top of the cabinet and selectively fluidically couple the second coupler to the condenser through the bottom of the cabinet, or any combination thereof. In at least one example, the compressor can compress the two-phase refrigerant received from the evaporator. In at least one example, the internal piping can fluidically couple the evaporator, the compressor, and the couplers.

In at least one example, the first through-pipe can be removably coupled to the first coupler. In at least one example, the second through-pipe can be removably coupled to the second coupler.

In at least one example, the first coupler can selectively isolate the evaporator from the condenser. In at least one example, the first coupler can include a first valve to selectively fluidically couple the evaporator to the condenser and/or selectively isolate the evaporator from the condenser. In at least one example, the first coupler can include a liquid line service port.

In at least one example, the second coupler can selectively isolate the compressor from the condenser. In at least one example, the second coupler can include a second valve to selectively fluidically couple the compressor to the condenser and/or selectively isolate the compressor from the condenser. In at least one example, the second coupler can include a compressor discharge service port.

In at least one example, the internal piping can include an isolatable section between the first coupler and the evaporator. In at least one example, a refrigerant drier can be plumbed within the isolatable section. In at least one example, a third coupler can be plumbed between the evaporator and the drier. In at least one example, the third coupler can selectively fluidically couple the evaporator to the drier and/or selectively isolate the evaporator from the drier. In at least one example, the third coupler can include a third valve to selectively fluidically couple the evaporator to the drier and/or selectively isolate the evaporator from the drier. In at least one example, the couplers can cooperate to isolate a first portion of the refrigerant in the internal piping, a second portion of the refrigerant in the through-pipes, a third portion of the refrigerant in the isolatable section, or any combination thereof. In at least one example, the couplers can permit the drier to be replaced without evacuating the first portion of the refrigerant and/or without evacuating the second portion of the refrigerant. In at least one example, the first, second, and third couplers can permit the drier to be replaced while the first portion of the refrigerant is isolated in the internal piping and the second portion of the refrigerant is isolated in the through-pipes.

In at least one example, a method of installing and/or maintaining an in-row cooling unit can include installing a cabinet of the cooling unit in a data center, loosening a first coupler within the cabinet fluidically coupled to internal piping rigidly mounted within the cabinet and an evaporator within the cabinet, moving a first through-pipe from a first bottom entry position to a first top entry position, tightening the first coupler, loosening a second coupler within the cabinet fluidically coupled to the internal piping rigidly mounted within the cabinet and a compressor within the cabinet, moving a second through-pipe from a second bottom entry position to a second top entry position, tightening the second coupler, coupling the through-pipes to a condenser external to the cabinet, or any combination thereof. In at least one example, tightening the first coupler can include fluidically coupling the first through-pipe to the evaporator in the first top entry position. In at least one example, tightening the second coupler can include fluidically coupling the second through-pipe to the compressor in the second top entry position.

In at least one example, loosening the first coupler can fluidically isolate the first through-pipe from the evaporator. In at least one example, moving the first through-pipe from the first bottom entry position to the first top entry position can include rotating the first through-pipe about the first coupler. In at least one example, tightening the first coupler can fluidically couple the first through-pipe to the evaporator through the internal piping.

In at least one example, loosening the second coupler can fluidically isolate the second through-pipe from the compressor. In at least one example, moving the second through-pipe from the second bottom entry position to the second top entry position can include rotating the second through-pipe about the second coupler. In at least one example, tightening the second coupler can fluidically couple the second through-pipe to the compressor through the internal piping.

In at least one example, a method of installing and/or maintaining an in-row cooling unit can include manipulating the first coupler, manipulating a third coupler plumbed between the first coupler and the evaporator, removing a first drier, installing a second drier between the first coupler and the third coupler, manipulating the first coupler and the third coupler again, or any combination thereof.

In at least one example, manipulating the first coupler can isolate the first drier from the evaporator and/or the condenser. In at least one example, manipulating the third coupler can isolate the first drier from the evaporator and/or the condenser. In at least one example, the first drier can be plumbed between the first coupler and the third coupler. In at least one example, manipulating the first coupler and the third coupler can fluidically couple the second drier with the evaporator and/or the condenser.

In at least one example, isolating the first drier from the evaporator and the condenser can include trapping a first portion of the refrigerant in the internal piping, the evaporator, and the compressor. In at least one example, isolating the first drier from the evaporator and the condenser can include trapping a second portion of the refrigerant in the through-pipes and the condenser. In at least one example, removing the first drier can include decoupling the first dryer from the first coupler and the third coupler without evacuating the first portion of the refrigerant and/or without evacuating the second portion of the refrigerant. In at least one example, the first drier can be swapped for the second drier without evacuating the first portion of the refrigerant and/or without evacuating the second portion of the refrigerant. In at least one example, removing the first drier can include decoupling the first dryer from the first coupler and the third coupler while the first portion of the refrigerant remains trapped in the internal piping, the evaporator, and the compressor, and while the second portion of the refrigerant remains trapped in the through-pipes and the condenser.

Other and further examples utilizing one or more aspects of the disclosure can be devised. For example, the devices, systems and methods can be implemented for numerous different types and sizes in numerous different industries. Further, the various methods and examples of the devices, systems and methods can be included in combination with each other to produce variations of the disclosed methods and examples. Discussion of singular elements can include plural elements and vice versa. The order of steps can occur in a variety of sequences unless otherwise specifically limited. The various steps described herein can be combined with other steps, interlineated with the stated steps, and/or split into multiple steps. Similarly, elements have been described functionally and can be embodied as separate components or can be combined into components having multiple functions.

Further examples are set out in the clauses below:
1. An in-row cooling unit comprising:
   a cabinet;
   an evaporator disposed within the cabinet and configured to transfer heat within the cabinet to a two-phase refrigerant within the evaporator;
   a compressor disposed within the cabinet, fluidically coupled to the evaporator, and configured to compress the two-phase refrigerant received from the evaporator;
   a first coupler configured to selectively fluidically couple the evaporator to a condenser which is disposed external to the cabinet;
   a second coupler configured to selectively fluidically couple the compressor to the condenser;
   internal piping rigidly mounted within the cabinet and fluidically coupling the evaporator, the compressor, and the first and second couplers;
   a first through-pipe configured to selectively fluidically couple the first coupler to the condenser through a top of the cabinet and selectively fluidically couple the first coupler to the condenser through a bottom of the cabinet; and
   a second through-pipe configured to selectively fluidically couple the second coupler to the condenser through the top of the cabinet and selectively fluidically couple the second coupler to the condenser through the bottom of the cabinet.
2. The cooling unit of clause 1, wherein the first through-pipe is removably coupled to the first coupler, and the second through-pipe is removably coupled to the second coupler.
3. The cooling unit of clause 1 or 2, wherein the first coupler is further configured to selectively isolate the evaporator from the condenser, and the second coupler is further configured to selectively isolate the compressor from the condenser.
4. The cooling unit of any one of the preceding clauses, wherein the first coupler comprises a first valve configured to selectively fluidically couple the evaporator to the condenser and selectively isolate the evaporator from the condenser; and
   wherein the second coupler comprises a second valve configured to selectively fluidically couple the compressor to the condenser and selectively isolate the compressor from the condenser.
5. The cooling unit of any one of the preceding clauses, wherein the internal piping further comprises an isolatable section between the first coupler and the evaporator.
6. The cooling unit of clause 5, further comprising a refrigerant drier plumbed within the isolatable section.
7. The cooling unit of clause 6, further comprising a third coupler plumbed between the evaporator and the drier, the third coupler configured to selectively fluidically couple the evaporator to the drier and selectively isolate the evaporator from the drier.
8. The cooling unit of clause 7, wherein the third coupler further comprises a third valve configured to selectively fluidically couple the evaporator to the drier and selectively isolate the evaporator from the drier.
9. The cooling unit of clause 8, wherein the first, second, and third couplers are configured to cooperate to isolate a first portion of the refrigerant in the internal piping, a second portion of the refrigerant in the through-pipes, and a third portion of the refrigerant in the isolatable section.
10. The cooling unit of clause 9, wherein the first, second, and third couplers permit the drier to be replaced without evacuating the first portion of the refrigerant and without evacuating the second portion of the refrigerant.
11. The cooling unit of clause 9, wherein the first, second, and third couplers permit the drier to be replaced while the first portion of the refrigerant is isolated in the internal piping and the second portion of the refrigerant is isolated in the through-pipes.
12.A method of installing an in-row cooling unit, the method comprising:
   installing a cabinet of the cooling unit in a data center;
   loosening a first coupler within the cabinet fluidically coupled to internal piping rigidly mounted within the cabinet and an evaporator within the cabinet;
   moving a first through-pipe from a first bottom entry position to a first top entry position;
   tightening the first coupler and fluidically coupling the first through-pipe to the evaporator in the first top entry position;
   loosening a second coupler within the cabinet fluidically coupled to the internal piping rigidly mounted within the cabinet and a compressor within the cabinet;
   moving a second through-pipe from a second bottom entry position to a second top entry position;
   tightening the second coupler and fluidically coupling the second through-pipe to the compressor in the second top entry position; and
   coupling the through-pipes to a condenser external to the cabinet.
13. The method of clause 12, wherein moving the first through-pipe from the first bottom entry position to the first top entry position further comprises rotating the first through-pipe about the first coupler.
14. The method of clause 12 or 13, wherein moving the second through-pipe from the second bottom entry position to the second top entry position further comprises rotating the second through-pipe about second first coupler.
15. The method of any one of clauses 12-14, wherein loosening the first coupler comprises fluidically isolating the first through-pipe from the evaporator, and
   wherein tightening the first coupler comprises fluidically coupling the first through-pipe to the evaporator through the internal piping.
16. The method of any one of clauses 12-15, wherein loosening the second coupler comprises fluidically isolating the second through-pipe from the compressor, and
   wherein tightening the second coupler comprises fluidically coupling the second through-pipe to the compressor through the internal piping.
17. The method of any one of clauses 12-16, further comprising:
   manipulating the first coupler;
   manipulating a third coupler plumbed between the first coupler and the evaporator and isolating a first drier from the evaporator and the condenser;
   removing the first drier;
   installing a second drier between the first coupler and the third coupler; and
   manipulating the first coupler and the third coupler and fluidically coupling the second drier with the evaporator and the condenser.
18. The method of clause 17, wherein isolating the first drier from the evaporator and the condenser comprises trapping a first portion of the refrigerant in the internal piping, the evaporator, and the compressor and trapping a second portion of the refrigerant in the through-pipes and the condenser.
19. The method of clause 18, wherein removing the first drier comprises decoupling the first dryer from the first coupler and the third coupler without evacuating the first portion of the refrigerant and without evacuating the second portion of the refrigerant.
20. The method of clause 18, wherein removing the first drier comprises decoupling the first dryer from the first coupler and the third coupler while the first portion of the refrigerant remains trapped in the internal piping, the evaporator, and the compressor, and while the second portion of the refrigerant remains trapped in the through-pipes and the condenser.

The inventions have been described in the context of preferred and other examples and not every example of the inventions has been described. Obvious modifications and alterations to the described examples are available to those of ordinary skill in the art having the benefits of the present disclosure. The disclosed and undisclosed examples are not intended to limit or restrict the scope or applicability of the inventions conceived of by the Applicant, but rather, in conformity with the patent laws, Applicant intends to fully protect all such modifications and improvements that come within the scope or range of equivalents of the following claims.

## Claims

1. An in-row cooling unit comprising:
a cabinet;
an evaporator disposed within the cabinet and configured to transfer heat within the cabinet to a two-phase refrigerant within the evaporator;
a compressor disposed within the cabinet, fluidically coupled to the evaporator, and configured to compress the two-phase refrigerant received from the evaporator;
a first coupler configured to selectively fluidically couple the evaporator to a condenser which is disposed external to the cabinet;
a second coupler configured to selectively fluidically couple the compressor to the condenser;
internal piping rigidly mounted within the cabinet and fluidically coupling the evaporator, the compressor, and the first and second couplers;
a first through-pipe configured to selectively fluidically couple the first coupler to the condenser through a top of the cabinet and selectively fluidically couple the first coupler to the condenser through a bottom of the cabinet; and
a second through-pipe configured to selectively fluidically couple the second coupler to the condenser through the top of the cabinet and selectively fluidically couple the second coupler to the condenser through the bottom of the cabinet.

2. The cooling unit of claim 1, wherein the first through-pipe is removably coupled to the first coupler, and the second through-pipe is removably coupled to the second coupler.

3. The cooling unit of claim 1 or 2, wherein the first coupler is further configured to selectively isolate the evaporator from the condenser, and the second coupler is further configured to selectively isolate the compressor from the condenser.

4. The cooling unit of any one of the preceding claims, wherein the first coupler comprises a first valve configured to selectively fluidically couple the evaporator to the condenser and selectively isolate the evaporator from the condenser; and
wherein the second coupler comprises a second valve configured to selectively fluidically couple the compressor to the condenser and selectively isolate the compressor from the condenser.

5. The cooling unit of any one of the preceding claims, wherein the internal piping further comprises an isolatable section between the first coupler and the evaporator.

6. The cooling unit of claim 5, further comprising a refrigerant drier plumbed within the isolatable section.

7. The cooling unit of claim 6, further comprising a third coupler plumbed between the evaporator and the drier, the third coupler configured to selectively fluidically couple the evaporator to the drier and selectively isolate the evaporator from the drier.

8. The cooling unit of claim 7, wherein the third coupler further comprises a third valve configured to selectively fluidically couple the evaporator to the drier and selectively isolate the evaporator from the drier.

9. The cooling unit of claim 8, wherein the first, second, and third couplers are configured to cooperate to isolate a first portion of the refrigerant in the internal piping, a second portion of the refrigerant in the through-pipes, and a third portion of the refrigerant in the isolatable section.

10. The cooling unit of claim 9, wherein the first, second, and third couplers permit the drier to be replaced without evacuating the first portion of the refrigerant and without evacuating the second portion of the refrigerant; or optionally
wherein the first, second, and third couplers permit the drier to be replaced while the first portion of the refrigerant is isolated in the internal piping and the second portion of the refrigerant is isolated in the through-pipes.

11. A method of installing an in-row cooling unit, the method comprising:
installing a cabinet of the cooling unit in a data center;
loosening a first coupler within the cabinet fluidically coupled to internal piping rigidly mounted within the cabinet and an evaporator within the cabinet;
moving a first through-pipe from a first bottom entry position to a first top entry position;
tightening the first coupler and fluidically coupling the first through-pipe to the evaporator in the first top entry position;
loosening a second coupler within the cabinet fluidically coupled to the internal piping rigidly mounted within the cabinet and a compressor within the cabinet;
moving a second through-pipe from a second bottom entry position to a second top entry position;
tightening the second coupler and fluidically coupling the second through-pipe to the compressor in the second top entry position; and
coupling the through-pipes to a condenser external to the cabinet.

12. The method of claim 11, wherein moving the first through-pipe from the first bottom entry position to the first top entry position further comprises rotating the first through-pipe about the first coupler; or optionally
wherein moving the second through-pipe from the second bottom entry position to the second top entry position further comprises rotating the second through-pipe about second first coupler; or optionally
wherein loosening the first coupler comprises fluidically isolating the first through-pipe from the evaporator, and
wherein tightening the first coupler comprises fluidically coupling the first through-pipe to the evaporator through the internal piping; or optionally
wherein loosening the second coupler comprises fluidically isolating the second through-pipe from the compressor, and
wherein tightening the second coupler comprises fluidically coupling the second through-pipe to the compressor through the internal piping.

13. The method of claim 11, further comprising:
manipulating the first coupler;
manipulating a third coupler plumbed between the first coupler and the evaporator and isolating a first drier from the evaporator and the condenser;
removing the first drier;
installing a second drier between the first coupler and the third coupler; and
manipulating the first coupler and the third coupler and fluidically coupling the second drier with the evaporator and the condenser.

14. The method of claim 13, wherein isolating the first drier from the evaporator and the condenser comprises trapping a first portion of the refrigerant in the internal piping, the evaporator, and the compressor and trapping a second portion of the refrigerant in the through-pipes and the condenser.

15. The method of claim 14, wherein removing the first drier comprises decoupling the first dryer from the first coupler and the third coupler without evacuating the first portion of the refrigerant and without evacuating the second portion of the refrigerant; or optionally
wherein removing the first drier comprises decoupling the first dryer from the first coupler and the third coupler while the first portion of the refrigerant remains trapped in the internal piping, the evaporator, and the compressor, and while the second portion of the refrigerant remains trapped in the through-pipes and the condenser.
